# EUROPÄISCHE PATENTANMELDUNG

(11) **EP 2 858 226 A2**
(43) Veröffentlichungstag der Anmeldung: **08.04.2015**
(21) Anmeldenummer: 14187481.8
(22) Anmeldetag: 02.10.2014
(51) Int. Cl.: H02M 3/335

(54) **Schaltungsanordnung zur Signalwandlung**

(30) Priorität: 04.10.2013 DE 102013111032; 22.10.2013 DE 102013111636; 11.04.2014 DE 102014105223
(71) Anmelder: PHOENIX CONTACT GmbH & Co. KG, 32825 Blomberg (DE)
(72) Erfinder: Jankowski, Martin, 30926 Seelze (DE)
(74) Vertreter: Blumbach Zinngrebe

(57) **Zusammenfassung**

Die Erfindung betrifft eine Schaltungsanordnung (5) zur Signalwandlung aufweisend
ein Schaltnetzteil (10) mit einem Transformator (60), an dessen Primärseite eine erste ansteuerbare Schalteinrichtung (120) zum Erzeugen eines Wechselsignal angeschaltet ist und an dessen Sekundärseite eine zweite ansteuerbare Schalteinrichtung (130) und ein Tiefpass (70, 75) angeschaltet sind, und
eine Steuereinrichtung (100) mit einem Eingang (110, 112) zum Anlegen eines Eingangssignals (uₑ), wobei die Steuereinrichtung (100) dazu ausgebildet ist, unter Ansprechen auf ein Eingangssignal (uₑ) die erste und zweite Schalteinrichtung (120, 130) derart anzusteuern, dass das Schaltnetzteil (10) ausgangsseitig (80, 82) ein dem Eingangssignal (uₑ) entsprechendes Ausgangssignal liefert.

## Beschreibung

Die Erfindung betrifft eine Schaltungsanordnung zur Signalwandlung, insbesondere zum Einsatz in einem Messwandler.

Bekannt sind Schaltnetzsteile, die ausgangsseitig eine Gleichspannung liefern. Potentialfreie Netzteile sind realisierbar, wenn Transformatoren verwendet werden.

Analogverstärker werden eingesetzt, um aus einem Eingangssignal am Verstärkerausgang eine Wechselspannung oder einen Wechselstrom zu erzeugen. Solche Analogverstärker haben jedoch eine geringe Energieeffizienz. Eine deutlich höhere Energieeffizienz kann mit sogenannten PWM (Pulsweitenmodulation)-Verstärkern oder Verstärkern der Klasse D, welche als Audioverstärker verwendet werden, erreicht werden. Allerdings ist der Ausgang eines solchen Verstärkers nicht potentialfrei. Zudem benötigt ein PWM-Verstärker eine geeignete Betriebsspannung.

Der Erfindung liegt die Aufgabe zugrunde, eine Schaltungsanordnung zur Signalwandlung zu schaffen, mit der energieeffizient an einem potentialfreien Ausgang beliebige Signale erzeugt werden können.

Ein Kerngedanke der Erfindung kann darin gesehen werden, den Betrieb eines Schaltnetzteils mit einem Mikrocontroller oder einem digitalen Signalprozessor zu steuern, wobei das Schaltnetzteil ausgangsseitig einen Polaritätswechsel durchführen kann, um am Ausgang insbesondere negative Gleichsignale oder Wechselsignale bereitzustellen.

Ein Gesichtspunkt der Erfindung kann darin gesehen werden, dass ein energieeffizienter Signalfolger mit Primärtaktung geschaffen wird, dessen Schaltelemente Halbleitertransistoren, insbesondere Feldeffekttransistoren aufweisen.

Das oben genannte technische Problem wird insbesondere durch die Merkmale des Anspruchs 1 und durch die Merkmale des Anspruchs 6 gelöst.

Vorteilhafte Ausgestaltungen sind Gegenstand der Unteransprüche

Die Erfindung wird nachfolgend anhand eines Ausführungsbeispiels in Verbindung mit den beiliegenden Zeichnungen näher erläutert. Es zeigen:
- Fig. 1: einen beispielhaften Strommesswandler, in welchem die Erfindung verwirklicht ist, und
- Fig. 2: Diagramme der Ansteuerungssignale der in Fig. 1 und 3 gezeigten Schalter,
- Fig. 3: eine besondere Ausgestaltung der Schaltelemente, des in Fig. 1 gezeigten Stromwandlers,
- Fig. 4: einen weiteren, beispielhaften Stromwandler, in welchem die Erfindung verwirklicht ist und
- Fig. 5: Diagramme der Ansteuerungssignale der in Fig. 4 gezeigten Schalter.

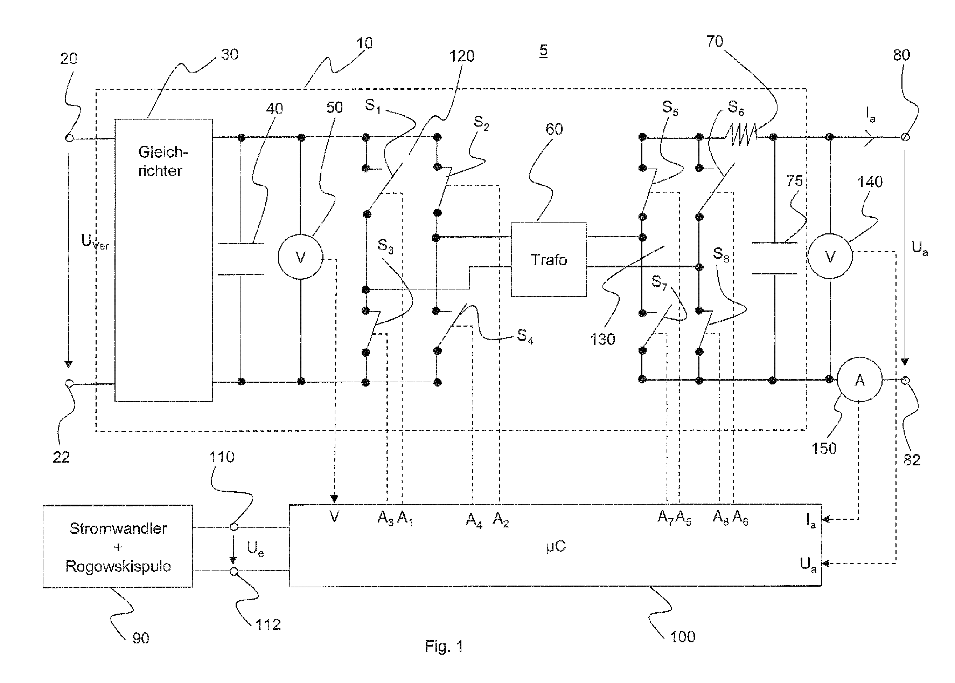

Fig. 1 zeigt eine beispielhafte Schaltungsanordnung 5 zur Signalwandlung, die als Strommesswandler betrieben werden kann.

Die Schaltungsanordnung 5 weist ein Schaltnetzteil 10 mit einem Ein- und Ausgang auf, welche jeweils zwei Eingangsklemmen 20, 22 bzw. zwei Ausgangsklemmen 80, 82 enthalten. An die Ausgangsklemmen 80, 82 kann eine Last (nicht dargestellt) angeschaltet werden. Sofern das Schaltnetzteil 10 von einer Netzspannung U_{Ver} versorgt wird, ist ein Gleichrichter 30 vorgesehen, welcher die eingangsseitige Netzspannung in eine Gleichspannung gleichrichtet. Wird das Schaltnetzteil 10 von einer Gleichspannung versorgt, kann der Gleichrichter 30 selbstverständlich entfallen.

In an sich bekannter Weise kann parallel zum Gleichrichter 30 ein Glättungskondensator 40 geschaltet sein, der die Welligkeit des gleichgerichteten Ausgangssignals des Gleichrichters 30 glättet. Weiterhin kann ein Spannungsmessgerät 50 angeschlossen sein, welches im vorliegenden Fall die am Kondensator 40 bzw. die an einer ersten Schalteinrichtung 120 anliegende Gleichspannung misst und je nach Implementierung die gemessene Gleichspannung als digitales oder analoges Ausgangssignal bereitstellt. Die erste Schalteinrichtung 120 fungiert als Zerhackereinrichtung. Bei der beispielhaft erläuterten Schaltungsanordnung 10 ist die erste Schalteinrichtung 120 als Vollbrücke ausgebildet, die vier Schaltelemente S1 bis S4 aufweist. Die Schaltelemente S1 bis S4 sind vorzugsweise Halbleitertransistoren. Die Schaltelemente S1 bis S4 dienen vornehmlich dazu, das gleichgerichtete Ausgangssignal des Gleichrichters 30 in ein Wechselsignal zu zerhacken, welches primärseitig an einen Transformator 60 angelegt werden kann. Das Schaltnetzteil 10 bildet insoweit einen regelbaren Gegentaktflusswandler in Vollbrücke.

An der Sekundärseite bzw. Sekundärwicklung des Transformators 60 ist eine zweite Schalteinrichtung 130 vorgesehen, die wiederum als Vollbrücke mit vier Schaltelementen S5 bis S8 ausgebildet sein kann. In Verbindung mit den Schaltelementen S1 bis S4 der ersten Schalteinrichtung 120 hat die zweite Schalteinrichtung die Aufgabe, ein gewünschtes Ausgangssignal zu liefern, wie dies weiter unten noch näher erläutert wird. Der zweiten Schalteinrichtung 130 folgt ein Tiefpassfilter, welches im vorliegenden Beispiel aus einer Spule 70 und einem Kondensator 75 gebildet wird. Der Kondensator 75 ist parallel an die Ausgangsklemmen 80, 82 des Transformators 60 angeschlossen. Parallel zum Kondensator 75 kann ein weiteres Spannungsmessgerät 140 geschaltet sein, welches die Ausgangsspannung Uₐ messen und als ein digitales oder analoges Ausgangssignal bereitstellen kann. In den mit der Anschlussklemme 82 verbundenen Strompfad der Schaltungsanordnung 5 kann ein Strommessgerät 150 geschaltet sein, welches den Ausgangsstrom des Schaltnetzteils 10 messen und als digitales oder analoges Ausgangssignal bereitstellen kann.

Die Schaltungsanordnung 5 weist weiterhin eine programmierbare Steuereinrichtung 100 auf, die als digitaler Signalprozessor oder als Mikrocontroller ausgebildet sein kann. Im dargestellten Beispiel handelt es sich bei der programmierbaren Steuereinrichtung 100 um einen Mikrocontroller. Der Mikrocontroller 100 weist einen Eingang mit Eingangsklemmen 110, 112 auf, an denen ein Eingangssignal, beispielsweise eine Messspannung oder ein Messstrom angelegt werden kann. Im vorliegenden Beispiel wird das Eingangsmesssignal von einem Stromwandler mit einer Rogowskispule 90 geliefert. Die Funktionsweise eines solchen Stromwandlers mit Rogowskispule ist hinlänglich bekannt und für die Erfindung ohne Bedeutung. Daher wird auf eine detaillierte Beschreibung des Stromwandlers 90 verzichtet. Angemerkt sei lediglich, dass neben der Rogowskispule ein Integrator vorgesehen ist, dessen Ausgangsspannung proportional zu dem Messstrom ist. Ein solcher Stromwandler wandelt sehr hohe Messströme in eine kleine Ausgangsspannung um, welche als Eingangsspannung Uₑ am Mikrocontroller 100 anliegt.

Angemerkt sei bereits an dieser Stelle, dass der Mikrocontroller 100 dazu ausgebildet ist, unter Ansprechen auf ein an den Eingangsklemmen 110 und 112 angelegtes Eingangssignal Uₑ die Schaltelemente S1 bis S8 derart anzusteuern, dass das Schaltnetzteil 10 an seinen Ausgangsklemmen ein dem Eingangssignal Uₑ entsprechend folgendes Ausgangssignal liefert. Insbesondere sorgt die Schaltungsanordnung 5 dafür, dass das Ausgangssignal des Schaltnetzteils 10 den Eingangsmessstrom des Stromwandlers 90 abbildet.

Der Mikrocontroller 100 ist demzufolge derart programmiert, dass er die Schaltelemente S1 bis S8 so ansteuern kann, dass an den Ausgangsklemmen 80, 82 in Abhängigkeit von einem gewählten Eingangssignal Uₑ Wechselsignale oder negative Gleichsignale erzeugt werden können. Das heißt, der Mikrocontroller 100 ist dazu ausgebildet, die Schalter S5 bis S8 als Polaritätswechsler zu betreiben.

Der Mikrocontroller 100 kann somit unter Ansprechen auf ein an den Eingangsklemmen 110, 112 anliegendes Eingangssignal die Schaltelemente S1 bis S8 derart ansteuern, dass das Schaltnetzteil 10 an den Ausgangsklemmen 80, 82 ein dem Eingangssignal entsprechendes Ausgangssignal liefert, gleichgültig, ob es sich beim Eingangssignal um ein Gleichsignal oder ein Wechselsignal handelt. In Verbindung mit dem Stromwandler 90, der eine Rogowskispule aufweist, sorgt der Mikrocontroller 100 dafür, dass der Ausgang des Schaltnetzteils 10 als 5A-Ausgang wirkt. Das bedeutet, dass der vom Stromwandler 90 gelieferte Wechselstrom, der als Wechselspannung an den Eingangsklemmen 110 und 112 des Mikrocontrollers 100 anliegt, in ein entsprechendes Wechselausgangssignal mit einem Effektivwert von 5A umgewandelt wird.

Der beispielhafte Mikrocontroller 100 weist ferner einen Eingang V auf, an welchen das Ausgangssignal des Spannungsmessgeräts 50 angelegt werden kann. Liegt das Ausgangsignal als Analogsignal vor, kann der Mikrocontroller 100 eine Analog/Digital-Wandlung vornehmen. Weiterhin verfügt der Mikrocontroller 100 über acht Ausgänge, die der Reihe nach mit A3, A1, A4, A2, A7, A5, A8 und A6 bezeichnet sind. An diesen Ausgängen liegen Steuersignale für Ansteuerung die jeweiligen Schaltern S1 bis S8 an. Der Mikrocontroller 100 verfügt über einen weiteren Eingang Iₐ, der mit dem Strommessgerät 150 verbunden ist. Liefert das Strommessgerät 150 ein analoges Ausgangssignal, kann der Mikrocontroller 100 dazu ausgebildet sein, eine Analog/Digital-Wandlung auszuführen. An einen Eingang Uₐ kann das Spannungsmessgerät 140 angeschlossen werden. Um die gewünschte Potentialfreiheit aufrecht erhalten zu können, müssen die Mess- und Steuersignale auf der Eingangs- und/oder Ausgangsseite des Mikrocontrollers 100 potentialgetrennt ausgeführt sein.

Der Mikrocontroller 100 kann die Höhe des Ausgangssignals des Schaltnetzteils 10 mit Hilfe der Schaltelemente S1 bis S4 in an sich bekannter Weise mittels Frequenzvariation und Puls-Pause-Verhältnissen regeln. Dank der Überwachung der Versorgungsspannung mit Hilfe des Spannungsmessgerätes 50 kann der Mikrocontroller 100 die Regelung an den aktuellen Wert der Versorgungsspannung U_{Ver} anpassen. Durch eine Rückmeldung des aktuellen Wertes des Ausgangsstroms Iₐ oder der Ausgangsspannung Uₐ kann der Mikrocontroller 100 zudem das Ausgangssignal des Schaltnetzteils 10 genau nachregeln. In all den beschriebenen Fällen stellt der Mikrocontroller 100 die geeigneten Steuersignale an den Ausgänge S1 bis S8 bereit.

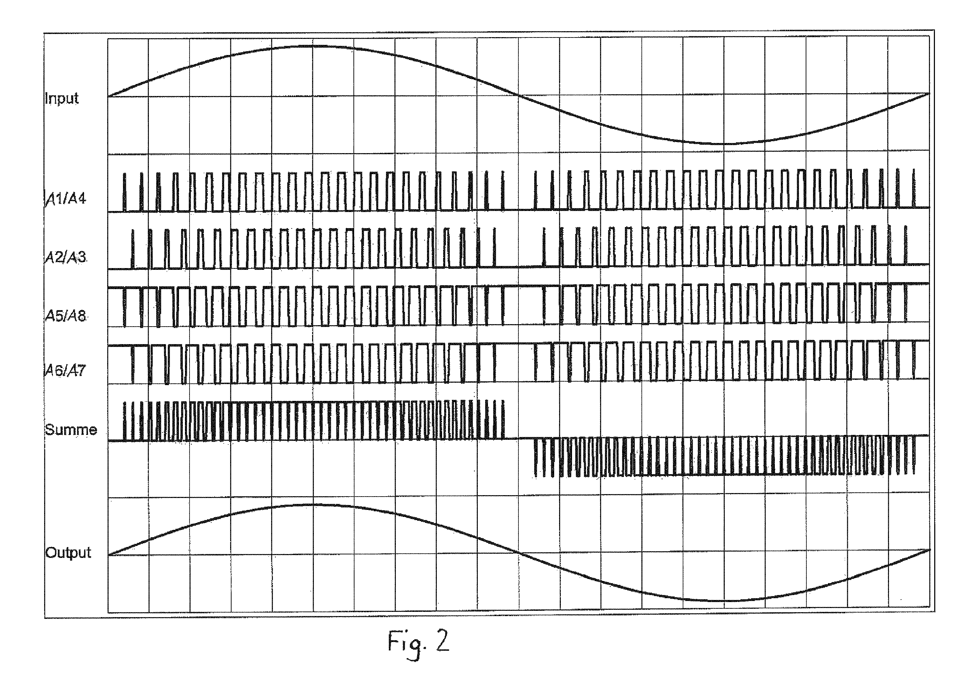

Die Funktionsweise der in Fig. 1 beispielhaft gezeigten, als Strommesswandler fungierenden Schaltungsanordnung 5 wird in Verbindung mit den in Fig. 2 dargestellten Zeitdiagrammen erläutert.

Angemerkt sei, dass bei der folgenden Beschreibung der Funktionsweise der Schaltungsanordnung 5 vorausgesetzt wird, dass die Versorgungsspannung an den Eingangsklemmen 20, 22 des Schaltnetzteils 10 konstant ist.

Weiterhin sei angemerkt, dass die Schaltungsanordnung 5 im vorliegenden Beispiel derart implementiert ist, dass ein in den Diagrammen dargestellter High-Pegel eines Steuersignals bedeutet, dass der jeweilige Schalter geschlossen ist, während ein Low-Pegel eines Steuersignals bedeutet, dass der jeweilige Schalter offen ist.

In Fig. 2 zeigt das obere Diagramm den zeitlichen Verlauf einer beispielsweise sinusförmigen Wechselspannung Uₑ an den Eingangsklemmen 110, 112 des Mikrocontrollers 100, welche dem Messstrom des Stromwandlers 90 entspricht. Darunter sind vier Zeitdiagramme dargestellt, welche die an den Ausgangspaaren A1/A4, A2/A3, A5/A8 und A6/A7 des Mikrocontrollers 100 anliegenden Steuersignale und die dazugehörenden Schaltzustände bezüglich der Schalterpaare S1/S4, S2/S3, S5/S8 und S6/S7 wiedergeben. Das Zeitdiagramm "Summe" stellt dann das Spannungssignal des Schaltnetzteils 10 vor dem Tiefpassfilter 70, 75 dar. Durchläuft das Summensignal das Tiefpassfilter 70, 75, so erscheint an den Ausgangsklemmen 80, 82 der Schaltungsanordnung 5 der im untersten Diagramm gezeigte Ausgangswechselstrom Iₐ mit einem Effektivwert von 5A. Der Ausgangswechselstrom folgt in vorgegebener Weise dem Eingangsmessstrom des Stromwandlers 90.

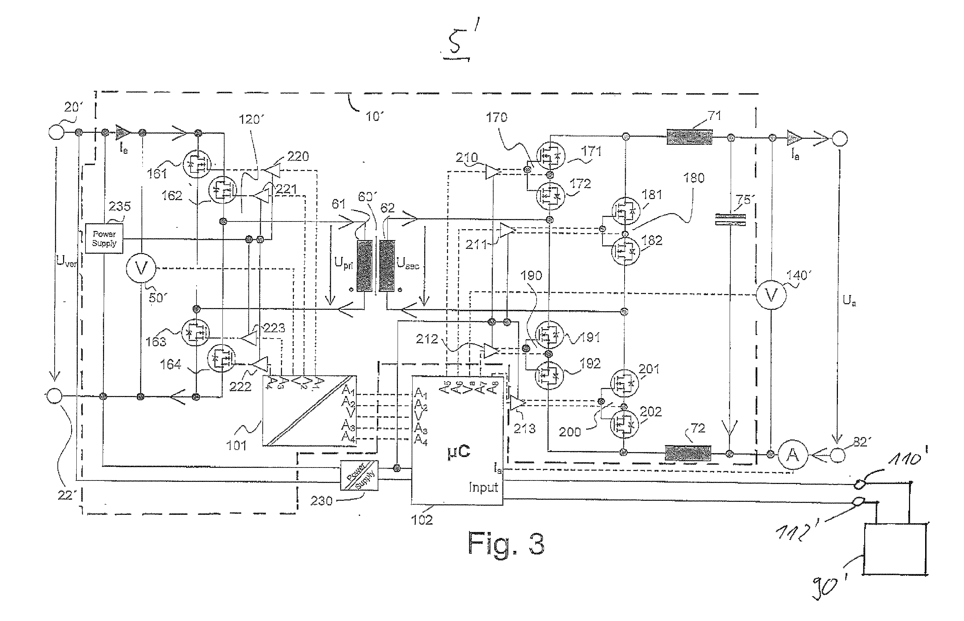

Fig. 3 zeigt eine beispielhafte Schaltungsanordnung 5' zur Signalwandlung, die als Strommesswandler betrieben werden kann.

Die Schaltungsanordnung 5' unterscheidet sich von der in Fig. 1 gezeigten Schaltungsanordnung 5 im Wesentlichen dadurch, dass die Schaltelemente S1 bis S8 durch Halbeiterschaltelemente, insbesondere durch niederohmige Feldeffekttransistoren realisiert sind.

Die Schaltungsanordnung 5' weist ein Schaltnetzteil 10' mit einem Ein- und Ausgang auf, welche jeweils zwei Eingangsklemmen 20', 22' bzw. zwei Ausgangsklemmen 80', 82' enthalten. An die Ausgangsklemmen 80', 82' kann eine Last (nicht dargestellt) angeschaltet werden. Die zur internen Energieversorgung der Schaltungsanordnung 5' erforderliche Gleichspannung kann beispielsweise von einer oder mehreren Spannungsversorgungseinrichtungen bereitgestellt werden, welche an die Eingangsklemmen 20' und 22' angeschlossen sind. Im vorliegenden Beispiel werden zwei Spannungsversorgungseinrichtungen 230 und 235 benutzt.

Weiterhin kann ein Spannungsmessgerät 50' angeschlossen sein, welches im vorliegenden Fall die an einer ersten Schalteinrichtung 120' anliegende Gleichspannung messen und die gemessene Gleichspannung als ein analoges oder digitales Ausgangssignal bereitstellen kann. Die erste Schalteinrichtung 120' fungiert als Zerhackereinrichtung. Bei der beispielhaft erläuterten Schaltungsanordnung 10 ist die erste Schalteinrichtung 120' als Vollbrücke ausgebildet, die vier Halbleiterschalteinrichtungen 161, 162, 163 und 164 aufweist. Die Halbleiterschalteinrichtungen 161 bis 164 sind vorzugsweise jeweils als Feldeffekttransistor ausgebildet und stellen eine konkrete Ausbildung der in Fig. 1 gezeigten Schaltelementen S1 bis S4 dar. Die Halbleiterschalteinrichtungen 161 bis 164 dienen vornehmlich dazu, die beispielsweise von einer externen Versorgungseinrichtung gelieferte und anschließend gleichgerichtete und geglättete Wechselspannung in ein Wechselsignal zu zerhacken, welches primärseitig an einen Transformator 60' angelegt werden kann. Eine solche externe Versorgungseinrichtung kann auch unmittelbar eine Gleichspannung liefern. Die Primärseite des Transformators 60' ist durch eine Primärwicklung 61 dargestellt, während die Sekundärseite des Transformators 60' durch eine Sekundärwicklung 62 symbolisiert wird. Das Schaltnetzteil 10' bildet insoweit einen regelbaren Gegentaktflusswandler in Vollbrücke.

An der Sekundärseite bzw. Sekundärwicklung 62 des Transformators 60' ist eine zweite Schalteinrichtung 130' vorgesehen, die wiederum als Vollbrücke mit vier Halbleiterschalteinrichtungen 170, 180, 190 und 200 ausgebildet sein kann. Jede Halbleiterschalteinrichtung weist zwei antiseriell geschaltete Halbleiterschalter, vorzugsweise zwei antiseriell geschaltete Feldeffekttransistoren auf. Die erste Halbleiterschalteinrichtung 170 weist zwei antiseriell geschaltete Feldeffekttransistoren 171 und 172 auf, die zweite Halbleiterschalteinrichtung 180 weist die beiden antiseriell geschalteten Feldeffekttransistoren 181 und 182 auf, die dritte Halbleiterschalteinrichtung 190 weist die beiden antiseriell geschalteten Feldeffekttransistoren 191 und 192 auf, während die vierte Halbleiterschalteinrichtung 200 die beiden antiseriell geschalteten Feldeffekttransistoren 201 und 202 aufweist. Diese antiserielle Verschaltung ist auch als Back-to-Back-Schaltung bekannt. Sie wird verwendet, um die durch die parasitären Dioden der Feldeffekttransistoren bedingten Nachteile zu vermeiden. Zu diesem Zweck wird jedes Feldeffekttransistorenpaar derart verschaltet, dass die jeweiligen Sourceanschlüsse miteinander verbunden sind, wie dies in Fig. 3 dargestellt ist. Um eine gemeinsame paarweise Ansteuerung zu ermöglichen, können, wie dargestellt, auch die jeweiligen Gateanschlüsse miteinander verbunden werden. Allerdings können die Feldeffekttransistoren 171 und 172, 181 und 182, 191 und 192 bzw. 201 und 202 auch einzeln angesteuert werden. Wie Fig. 3 zeigt, haben die Gateanschlüsse und Sourceanschlüsse der Feldeffekttransistoren 171 und 172, die Gateanschlüsse und Sourceanschlüsse der Feldeffekttransistoren 181 und 182, die Gateanschlüsse und Sourceanschlüsse der Feldeffekttransistoren 191 und 192 und die Gateanschlüsse und Sourceanschlüsse der Feldeffekttransistoren 201 und 202 jeweils einen gemeinsamen Verbindungspunkt. Die vier Halbleiterschalteinrichtungen 170, 180, 190 und 200 können als eine konkrete Ausbildungsform der in Fig. 1 gezeigten Schaltelemente S5 bis S8 betrachtet werden.

In Verbindung mit den Halbleiterschalter 161 bis 164 der ersten Schalteinrichtung 120' hat die zweite Schalteinrichtung 130' die Aufgabe, ein gewünschtes Ausgangssignal zu liefern, wie dies weiter unten noch näher erläutert wird. Der zweiten Schalteinrichtung 130' folgt ein Tiefpassfilter, welches im vorliegenden Beispiel aus einer Spule 71, einer zweiten Spule 72 und einem Kondensator 75' gebildet wird. Die erste Spule 71 ist mit der Ausgangsklemme 80' und den Drainanschlüssen der Feldeffekttransistoren 171 und 181 verbunden, während die zweite Spule 72 mit der Ausgangsklemme 82' und den Drainanschlüssen der Feldeffekttransistoren 192 und 202 verbunden ist. Der Kondensator 75' ist parallel an die Ausgangsklemmen 80', 82' angeschlossen. Parallel zum Kondensator 75' kann ein weiteres Spannungsmessgerät 140' geschaltet sein, welches die Ausgangsspannung Uₐ messen und als ein digitales oder analoges Ausgangssignal bereitstellen kann. In den mit der Anschlussklemme 82' verbundenen Strompfad der Schaltungsanordnung 5' kann ein Strommessgerät 150' geschaltet sein, welches den Ausgangsstrom des Schaltnetzteils 10' messen und als digitales oder analoges Ausgangssignal bereitstellen kann.

Die Schaltungsanordnung 5' weist weiterhin eine vorzugsweise programmierbare Steuereinrichtung 102 auf, die als digitaler Signalprozessor oder als Mikrocontroller ausgebildet sein kann. Im dargestellten Beispiel handelt es sich bei der Steuereinrichtung 102 um einen Mikrocontroller. Der Mikrocontroller 100 weist einen Eingang mit Eingangsklemmen 110', 112' auf, an denen ein Eingangssignal, beispielsweise eine Messspannung oder ein Messstrom angelegt werden kann. Im vorliegenden Beispiel wird das Eingangsmesssignal von einem Stromwandler mit einer Rogowskispule 90' geliefert. Die Funktionsweise eines solchen Stromwandlers mit Rogowskispule ist hinlänglich bekannt und für die Erfindung ohne Bedeutung. Daher wird auf eine detaillierte Beschreibung des Stromwandlers 90' verzichtet. Angemerkt sei lediglich, dass neben der Rogowskispule ein Integrator vorgesehen ist, dessen Ausgangsspannung proportional zu dem Messstrom ist. Ein solcher Stromwandler wandelt sehr hohe Messströme in eine kleine Ausgangsspannung um, welche als Eingangsspannung Uₑ am Mikrocontroller 102 anliegt.

Angemerkt sei bereits an dieser Stelle, dass der Mikrocontroller 102 dazu ausgebildet sein kann, unter Ansprechen auf ein an den Eingangsklemmen 110' und 112' angelegtes Eingangssignal Uₑ die Halbleiterschalter 161 bis 164 und die Halbleiterschalter der Halbleiterschalteinrichtungen 170, 180, 190 und 200 derart anzusteuern, dass das Schaltnetzteil 10' an seinen Ausgangsklemmen ein dem Eingangssignal Uₑ entsprechend folgendes Ausgangssignal liefert. Insbesondere sorgt die Schaltungsanordnung 5' dafür, dass das Ausgangssignal des Schaltnetzteils 10' den Eingangsmessstrom des Stromwandlers 90 abbildet.

Der Mikrocontroller 102 ist demzufolge derart programmiert, dass er die Halbleiterschalter 161 bis 164 und die Halbleiterschalter 171 und 172, 181 und 182, 191 und 192 sowie 201 und 202 der Halbleiterschalteinrichtungen 170, 180, 190 bzw. 200 so ansteuern kann, dass an den Ausgangsklemmen 80', 82' in Abhängigkeit von einem gewählten Eingangssignal Uₑ Wechselsignale oder negative Gleichsignale erzeugt werden können. Das heißt, der Mikrocontroller 102 ist dazu ausgebildet, die Halbleiterschalter 171 und 172, 181 und 182, 191 und 192 sowie 201 und 202 der Halbleiterschalteinrichtungen 170, 180, 190 bzw. 200 als Polaritätswechsler zu betreiben.

Der Mikrocontroller 102 kann somit unter Ansprechen auf ein an den Eingangsklemmen 110', 112' anliegendes Eingangssignal die Halbleiterschalter 161 bis 164 und die Halbleiterschalter der Halbleiterschalteinrichtungen 170, 180, 190 und 200 derart ansteuern, dass das Schaltnetzteil 10' an den Ausgangsklemmen 80', 82' ein dem Eingangssignal entsprechendes Ausgangssignal liefert, gleichgültig, ob es sich beim Eingangssignal um ein Gleichsignal oder ein Wechselsignal handelt. In Verbindung mit dem Stromwandler 90' kann der Mikrocontroller 102 dafür, dass der Ausgang des Schaltnetzteils 10' als 5A-Ausgang wirkt. Das bedeutet, dass der vom Stromwandler 90' gelieferte Wechselstrom, der als Wechselspannung an den Eingangsklemmen 110' und 112' des Mikrocontrollers 102 anliegt, in ein entsprechendes Wechselausgangssignal mit einem Effektivwert von 5A umgewandelt wird.

Der beispielhafte Mikrocontroller 102 weist ferner einen Eingang V auf, an welchen das Ausgangssignal des Spannungsmessgeräts 50' angelegt werden kann. Ist das Ausgangssignal ein Analogsignal, kann der Mikrocontroller 102 eine Analog/Digital-Wandlung mit dem empfangenen Ausgangssignal ausführen. Weiterhin verfügt der Mikrocontroller 102 über acht Ausgänge, die mit A1 bis A8 gekennzeichnet sind. An diesen Ausgängen liegen die Steuersignale zur Ansteuerung der Halbleiterschalter 161 bis 164 und der Halbleiterschalter 171 und 172, 181 und 182, 191 und 192 sowie 201 und 202 der Halbleiterschalteinrichtungen 170, 180, 190 bzw. 200 an. Der Mikrocontroller 102 verfügt über einen weiteren Eingang Iₐ, der mit dem Strommessgerät 150' verbunden ist. An einen Eingang Uₐ kann das Spannungsmessgerät 140' angeschlossen werden.

Um die gewünschte Potentialfreiheit aufrecht erhalten zu können, müssen die Mess- und Steuersignale auf der Eingangs- und/oder Ausgangsseite des Mikrocontrollers 102 potentialgetrennt ausgeführt sein.

Bei der beispielhaften Ausbildungsform nach Fig. 3 sind die Ausgänge A1 bis A4 und der Eingang V des Mikrocontrollers 102 mit entsprechend bezeichneten Eingängen A1 bis A4 bzw. einem Ausgang V einer Potentialtrennungsstufe 101 verbunden, die für die Potentialtrennung sorgt. Die Potentialtrennungsstufe 101 weist wiederum Ausgänge A1 bis A4 und einen Eingang V auf, welche den Ausgängen A1 bis A4 und dem Eingang V des Mikrocontrollers 102 entsprechen. Hierbei ist der Ausgang A1 der Potentialtrennungsstufe 101 vorzugsweise über einen Signalverstärker 220 mit dem Gate des Feldeffekttransistors 161 verbunden, der Ausgang A2 der Potentialtrennungsstufe 101 vorzugsweise über einen Signalverstärker 221 mit dem Gate des Feldeffekttransistors 162 verbunden, der Ausgang A3 der Potentialtrennungsstufe 101 vorzugsweise über einen Signalverstärker 223 mit dem Gate des Feldeffekttransistors 163 verbunden und der Ausgang A4 der Potentialtrennungsstufe 101 vorzugsweise über einen Signalverstärker 222 mit dem Gate des Feldeffekttransistors 164 verbunden. An den Eingang V der Potentialtrennungsstufe 101 ist das Spannungsmessgerät 50' angeschlossen.

Der Ausgang A5 des Mikrocontrollers 102 ist vorzugsweise über einen Signalverstärker 210 mit dem Gateanschluss-Verbindungspunkt und dem Sourceanschluss-Verbindungspunkt der Feldeffekttransistoren 171 und 172 verbunden. Der Ausgang A6 des Mikrocontrollers 102 ist vorzugsweise über einen Signalverstärker 211 mit dem Gateanschluss-Verbindungspunkt und dem Sourceanschluss-Verbindungspunkt der Feldeffekttransistoren 181 und 182 verbunden. Der Ausgang A7 des Mikrocontrollers 102 ist vorzugsweise über einen Signalverstärker 212 mit dem Gateanschluss-Verbindungspunkt und dem Sourceanschluss-Verbindungs der Feldeffekttransistoren 191 und 192 verbunden. Der Ausgang A8 des Mikrocontrollers 102 ist vorzugsweise über einen Signalverstärker 213 mit dem Gateanschluss-Verbindungspunkt und dem Sourceanschluss-Verbindungspunkt der Feldeffekttransistoren 201 und 202 verbunden. Der Eingang Uₐ des Mikrocontrollers 102 ist mit dem Spannungsmessgerät 140' verbunden, während der Eingang Iₐ mit dem Stromessgerät 150' verbunden.

Der Mikrocontroller 102 kann die Höhe des Ausgangssignals des Schaltnetzteils 10' mit Hilfe der Halbleiterschalter 161 bis 164 in an sich bekannter Weise mittels Frequenzvariation und Puls-Pause-Verhältnissen regeln. Dank der Überwachung der Versorgungsspannung mit Hilfe des Spannungsmessgerätes 50' kann der Mikrocontroller 102 die Regelung an den aktuellen Wert der Versorgungsspannung U_{Ver} anpassen. Durch eine Rückmeldung des aktuellen Wertes des Ausgangsstroms Iₐ und/oder der Ausgangsspannung Uₐ kann der Mikrocontroller 102 zudem das Ausgangssignal des Schaltnetzteils 10' genau nachregeln. In all den beschriebenen Fällen stellt der Mikrocontroller 102 die geeigneten Steuersignale an den Ausgänge A1 bis A8 bereit.

Angemerkt sei noch, dass die Spannungsversorgungseinrichtung 235 die Signalverstärker 220 bis 223 und die Spannungsversorgungseinrichtung 230 die Signalverstärker 210 bis 213 und den Mikrocontroller mit Energie speisen können.

Die Funktionsweise der in Fig. 3 beispielhaft gezeigten, als Strommesswandler fungierenden Schaltungsanordnung 5' kann ebenfalls in Verbindung mit den in Fig. 2 dargestellten Zeitdiagrammen erläutert.

Angemerkt sei, dass bei der folgenden Beschreibung der Funktionsweise der Schaltungsanordnung 5' vorausgesetzt wird, dass die Versorgungsspannung an den Eingangsklemmen 20', 22' des Schaltnetzteils 10' konstant ist.

Weiterhin sei angemerkt, dass die Schaltungsanordnung 5' im vorliegenden Beispiel derart implementiert ist, dass ein in den Diagrammen dargestellter High-Pegel eines Steuersignals bedeutet, dass der jeweilige Schalter geschlossen ist, während ein Low-Pegel eines Steuersignals bedeutet, dass der jeweilige Schalter offen ist.

In Fig. 2 zeigt das obere Diagramm den zeitlichen Verlauf einer sinusförmigen Eingangsspannung Uₑ an den Eingangsklemmen 110', 112' des Mikrocontrollers 102, welche dem Messstrom des Stromwandlers 90' entspricht. Darunter sind vier Zeitdiagramme dargestellt, welche die an den Ausgangspaaren A1/A4, A2/A3, A5/A8 und A6/A7 des Mikrocontrollers 102 anliegenden Steuersignale und die entsprechenden Schaltzustände bezüglich der Halbleiterschalteinrichtungspaare 161/164, 162/163, 170/200 und 180/190 wiedergeben. Das Zeitdiagramm "Summe" stellt dann das Spannungssignal des Schaltnetzteils 10' vor dem Tiefpassfilter 71, 72, 75' dar. Durchläuft das Summensignal das Tiefpassfilter 71, 72, 75', so erscheint an den Ausgangsklemmen 80', 82' der Schaltungsanordnung 5' der im untersten Diagramm gezeigte Ausgangswechselstrom Iₐ mit einem Effektivwert von 5A. Der Ausgangswechselstrom folgt in vorgegebener Weise dem Eingangsmessstrom des Stromwandlers 90'.

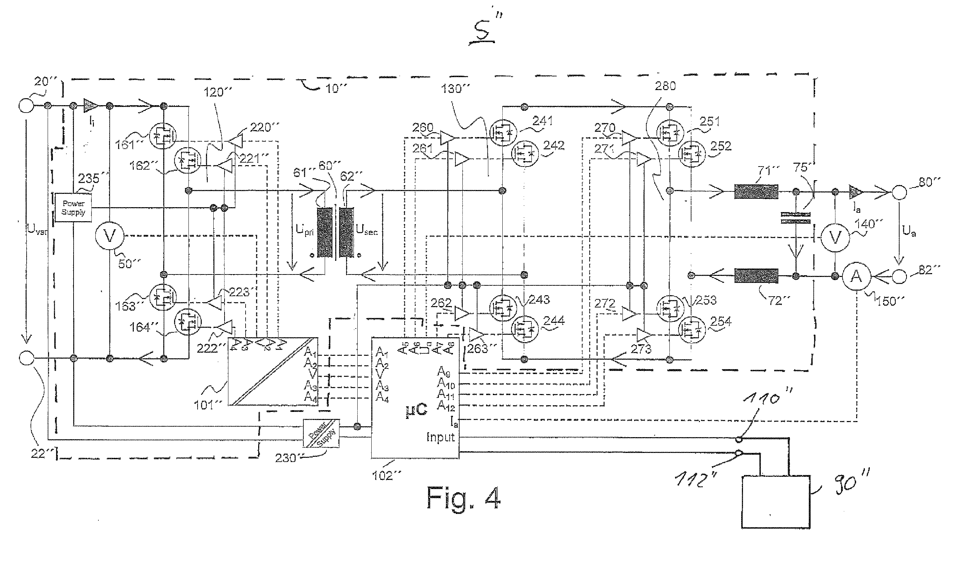

Fig. 4 zeigt eine weitere beispielhafte Schaltungsanordnung 5'' zur Signalwandlung, die als Strommesswandler betrieben werden kann.

Die Schaltungsanordnung 5'' unterscheidet sich von der in Fig. 1 gezeigten Schaltungsanordnung 5 im Wesentlichen dadurch, dass eine dritte Schalteinrichtung 280 vorhanden ist. Diese Schaltungsanordnung zeichnet sich insbesondere durch einen nachgeschalteten Wechselrichter aus.

Die Schaltungsanordnung 5'' weist ein Schaltnetzteil 10'' mit einem Ein- und Ausgang auf, welche jeweils zwei Eingangsklemmen 20'', 22'' bzw. zwei Ausgangsklemmen 80'', 82'' enthalten. An die Ausgangsklemmen 80'', 82'' kann eine Last (nicht dargestellt) angeschaltet werden. Die zur internen Energieversorgung der Schaltungsanordnung 5'' erforderliche Gleichspannung kann beispielsweise von einer oder mehreren Spannungsversorgungseinrichtungen bereitgestellt werden, welche an die Eingangsklemmen 20'' und 22'' angeschlossen sind. Im vorliegenden Beispiel werden zwei parallel geschaltete Spannungsversorgungseinrichtungen 230'' und 235'' benutzt.

Weiterhin kann ein Spannungsmessgerät 50'' angeschlossen sein, welches im vorliegenden Fall die an einer ersten Schalteinrichtung 120'' anliegende Gleichspannung messen und als analoges oder digitales Ausgangssignal bereitstellen kann. Die erste Schalteinrichtung 120'' fungiert als Zerhackereinrichtung. Bei der beispielhaft erläuterten Schaltungsanordnung 10" ist die erste Schalteinrichtung 120" als Vollbrücke ausgebildet, die vier Halbleiterschaltelemente 161'', 162'', 163" und 164" aufweist. Die Halbleiterschaltelement 161" bis 164" sind vorzugsweise als Feldeffekttransistoren ausgebildet und stellen eine konkrete Ausbildung der in Fig. 1 gezeigten Schaltelementen S1 bis S4 dar. Die Halbleiterschaltelemente 161" bis 164" dienen vornehmlich dazu, eine von einer externen Spannungsversorgungseinrichtung bereitgestellte Gleichspannung oder ein von einer externen Versorgungseinrichtung bereitgestelltes und anschließend gleichgerichtetes und geglättetes Wechselsignal zu zerhacken, welches primärseitig an einen Transformator 60" angelegt werden kann. Die Primärseite des Transformators 60" ist durch eine Primärwicklung 61" dargestellt, während die Sekundärseite des Transformators 60" durch eine Sekundärwicklung 62" symbolisiert wird. Das Schaltnetzteil 10" bildet insoweit einen regelbaren Gegentaktflusswandler in Vollbrücke.

An der Sekundärseite bzw. Sekundärwicklung 62" des Transformators 60" ist eine zweite Schalteinrichtung 130" vorgesehen, die wiederum als Vollbrücke mit vier Halbleiterschaltelementen 241 bis 244 ausgebildet sein kann. Die Halbleiterschaltelemente können als niederohmige Feldeffekttransistoren ausgebildet sein. Die vier Halbleiterschaltelemente 241 bis 244 können als eine konkrete Ausbildungsform der in Fig. 1 gezeigten Schaltelemente S5 bis S8 betrachtet werden.

Der zweiten Schalteinrichtung 130" ist eine dritte Schalteinrichtung 280 nachgeschaltet, die als Vollbrücke mit vier Halbleiterschaltelementen 251 bis 254 ausgebildet sein kann. Die Halbleiterschaltelemente 251 bis 254 können wiederum als niederohmige Feldeffekttransistoren ausgebildet sein. Bei der in Fig. 4 beispielhaft gezeigten Ausführungsform ist der Sourceanschluss des Feldeffekttransistors 241 und der Drainanschluss des Feldeffekttransistors 244 mit einem Anschluss der Sekundärwicklung 62" verbunden, während der Sourceanschluss des Feldeffekttransistors 242 und der Drainanschluss des Feldeffekttransistors 243 mit dem anderen Anschluss der Sekundärwicklung 62'' verbunden ist. Die Drainanschlüsse der Feldeffekttransistoren 241 und 242 sind mit den Drainanschlüssen der Feldeffekttransistoren 251 und 252 verbunden, während die Sourceanschlüsse der Feldeffekttransistoren 243 und 244 mit den Sourceanschlüssen der Feldeffekttransistoren 253 und 254 verbunden sind. In Verbindung mit den Halbleiterschaltelementen 161 bis 164 der ersten Schalteinrichtung 120' haben die zweite Schalteinrichtung 130' und die dritte Schalteinrichtung 280 die Aufgabe, ein gewünschtes Ausgangssignal zu liefern, wie dies weiter unten noch näher erläutert wird. Die zweite Schalteinrichtung 130" bildet hierbei den Gleichrichter, während die dritte Schalteinrichtung 280 einen nachgeschalteten Wechselrichter bildet.

Der dritten Schalteinrichtung 280 folgt ein Tiefpassfilter, welches im vorliegenden Beispiel aus einer Spule 71'', einer zweiten Spule 72'' und einem Kondensator 75'' gebildet wird. Ein Anschluss der ersten Spule 71'' ist mit der Ausgangsklemme 80'' und der andere Anschluss ist mit dem Sourcesanchluss des Feldeffekttransistors 251 sowie dem Drainanschluss des Feldeffekttransistors 253 verbunden, während ein Anschluss der zweiten Spule 72'' mit der Ausgangsklemme 82'' und der andere Anschluss mit dem Sourceanschluss des Feldeffekttransistors 252 und dem Drainanschluss des Feldeffekttransistors 254 verbunden ist. Der Kondensator 75'' ist parallel an den Ausgangsklemmen 80'', 82'' angeschlossen. Parallel zum Kondensator 75'' kann ein weiteres Spannungsmessgerät 140'' geschaltet sein, welches die Ausgangsspannung Uₐ messen und in ein digitales Ausgangssignal umwandeln kann. In den mit der Anschlussklemme 82'' verbundenen Strompfad der Schaltungsanordnung 5'' kann ein Strommessgerät 150'' geschaltet sein, welches den Ausgangsstrom des Schaltnetzteils 10'' messen und als ein digitales oder analoges Ausgangssignal bereitstellen kann.

Die Schaltungsanordnung 5'' weist weiterhin eine vorzugsweise programmierbare Steuereinrichtung 102'' auf, die als digitaler Signalprozessor oder als Mikrocontroller ausgebildet sein kann. Im dargestellten Beispiel handelt es sich bei der Steuereinrichtung 102'' um einen Mikrocontroller. Der Mikrocontroller 102'' weist einen Eingang mit Eingangsklemmen 110'', 112'' auf, an denen ein Eingangssignal, beispielsweise eine Messspannung oder ein Messstrom angelegt werden kann. Im vorliegenden Beispiel wird das Eingangsmesssignal von einem Stromwandler mit einer Rogowskispule 90'' geliefert. Die Funktionsweise eines solchen Stromwandlers mit Rogowskispule ist hinlänglich bekannt und für die Erfindung ohne Bedeutung. Daher wird auf eine detaillierte Beschreibung des Stromwandlers 90" verzichtet. Angemerkt sei lediglich, dass neben der Rogowskispule ein Integrator vorgesehen ist, dessen Ausgangsspannung proportional zu dem Messstrom ist. Ein solcher Stromwandler wandelt sehr hohe Messströme in eine kleine Ausgangsspannung um, welche als Eingangsspannung Uₑ am Mikrocontroller 102'' anliegt.

Angemerkt sei bereits an dieser Stelle, dass der Mikrocontroller 102" dazu ausgebildet sein kann, unter Ansprechen auf ein an den Eingangsklemmen 110" und 112" angelegtes Eingangssignal Uₑ die Halbleiterschaltelemente 161" bis 164' und die Halbleiterschaltelemente 241 bis 244 und 251 bis 254 derart anzusteuern, dass das Schaltnetzteil 10" an seinen Ausgangsklemmen ein dem Eingangssignal Uₑ entsprechend folgendes Ausgangssignal liefert. Insbesondere sorgt die Schaltungsanordnung 5" dafür, dass das Ausgangssignal des Schaltnetzteils 10" den Eingangsmessstrom des Stromwandlers 90" abbildet.

Der Mikrocontroller 102" ist demzufolge derart programmiert, dass er die Halbleiterschaltelemente 161" bis 164" und die Halbleiterschaltelemente 241 bis 244 und 251 bis 254 so ansteuern kann, dass an den Ausgangsklemmen 80'', 82'' in Abhängigkeit von einem gewählten Eingangssignal Uₑ Wechselsignale oder negative Gleichsignale erzeugt werden können. Das heißt, der Mikrocontroller 102" ist dazu ausgebildet, die Halbleiterschaltelemente 161" bis 164" und die Halbleiterschaltelemente 241 bis 244 und 251 bis 254 gezielt anzusteuern, wobei die Halbleiterschaltelemente 251 bis 254 als Polaritätswechsler betrieben werden.

Der Mikrocontroller 102'' kann somit unter Ansprechen auf ein an den Eingangsklemmen 110'', 112'' anliegendes Eingangssignal die Halbleiterschaltelemente 161" bis 164" und die Halbleiterschaltelemente 241 bis 244 und 251 bis 254 derart ansteuern, dass das Schaltnetzteil 10'' an den Ausgangsklemmen 80'', 82'' ein dem Eingangssignal entsprechendes Ausgangssignal liefert, gleichgültig, ob es sich beim Eingangssignal um ein Gleichsignal oder ein Wechselsignal handelt. In Verbindung mit dem Stromwandler 90' kann der Mikrocontroller 102'' dafür, dass der Ausgang des Schaltnetzteils 10' als 5A-Ausgang wirkt. Das bedeutet, dass der vom Stromwandler 90'' gelieferte Wechselstrom, der als Wechselspannung an den Eingangsklemmen 110'' und 112'' des Mikrocontrollers 102'' anliegt, in ein entsprechendes Wechselausgangssignal mit einem Effektivwert von 5A umgewandelt wird.

Der beispielhafte Mikrocontroller 102'' weist ferner einen Eingang V auf, an welchen das Ausgangssignal des Spannungsmessgeräts 50'' angelegt werden kann. Weiterhin verfügt der Mikrocontroller 102'' über zwölf Ausgänge, die mit A1 bis A12 bezeichnet sind. An diesen Ausgängen liegen die Steuersignale zur Ansteuerung der Halbleiterschaltelemente 161" bis 164' und der Halbleiterschaltelemente 241 bis 244 und 251 bis 254 an. Der Mikrocontroller 102'' verfügt über einen weiteren Eingang Iₐ, der mit dem Strommessgerät 150'' verbunden ist. An einen Eingang Uₐ kann das Spannungsmessgerät 140'' angeschlossen werden.

Um die gewünschte Potentialfreiheit aufrecht erhalten zu können, müssen die Mess- und Steuersignale auf der Eingangs- und/oder Ausgangsseite des Mikrocontrollers 102 potentialgetrennt ausgeführt sein.

Bei der beispielhaften Ausbildungsform nach Fig. 4 sind die Ausgänge A1 bis A4 und der Eingang V des Mikrocontrollers 102'' mit entsprechend bezeichneten Eingängen A1 bis A4 bzw. einem Ausgang V einer Potentialtrennungsstufe 101'' verbunden, welche für die gewünschte Potentialtrennung sorgt. Die Potentialtrennungsstufe 101'' weist wiederum Ausgänge A1 bis A4 und einen Eingang V auf, welche den Ausgängen A1 bis A4 und dem Eingang V des Mikrocontrollers 102'' entsprechen. Hierbei ist der Ausgang A1 der Potentialtrennungsstufe 101'' vorzugsweise über einen Signalverstärker 220'' mit dem Gate des Feldeffekttransistors 161" verbunden, der Ausgang A2 der Potentialtrennungsstufe 101'' vorzugsweise über einen Signalverstärker 221'' mit dem Gate des Feldeffekttransistors 162'' verbunden, der Ausgang A3 der Potentialtrennungsstufe 101'' vorzugsweise über einen Signalverstärker 223'' mit dem Gate des Feldeffekttransistors 163'' verbunden und der Ausgang A4 der Potentialtrennungsstufe 101'' vorzugsweise über einen Signalverstärker 222'' mit dem Gate des Feldeffekttransistors 164'' verbunden. An den Eingang V der Potentialtrennungsstufe 101'' ist das Spannungsmessgerät 50'' angeschlossen.

Der Ausgang A5 des Mikrocontrollers 102'' ist vorzugsweise über einen Signalverstärker 260 mit dem Gateanschluss des Feldeffekttransistors 241. Der Ausgang A6 des Mikrocontrollers 102'' ist vorzugsweise über einen Signalverstärker 261 mit dem Gateanschluss des Feldeffekttransistors 242. Der Ausgang A7 des Mikrocontrollers 102'' ist vorzugsweise über einen Signalverstärker 262 mit dem Gateanschluss des Feldeffekttransistors 244. Der Ausgang A8 des Mikrocontrollers 102'' ist vorzugsweise über einen Signalverstärker 263 mit dem Gateanschluss des Feldeffekttransistors 243. Der Ausgang A9 des Mikrocontrollers 102'' ist vorzugsweise über einen Signalverstärker 270 mit dem Gateanschluss des Feldeffekttransistors 251. Der Ausgang A10 des Mikrocontrollers 102'' ist vorzugsweise über einen Signalverstärker 271 mit dem Gateanschluss des Feldeffekttransistors 252. Der Ausgang A11 des Mikrocontrollers 102'' ist vorzugsweise über einen Signalverstärker 272 mit dem Gateanschluss des Feldeffekttransistors 253. Der Ausgang A5 des Mikrocontrollers 102'' ist vorzugsweise über einen Signalverstärker 273 mit dem Gateanschluss des Feldeffekttransistors 254. Der Eingang Uₐ des Mikrocontrollers 102'' ist mit dem Spannungsmessgerät 140'' verbunden, während der Eingang Iₐ mit dem Stromessgerät 150'' verbunden.

Der Mikrocontroller 102'' kann die Höhe des Ausgangssignals des Schaltnetzteils 10'' mit Hilfe der Schaltelemente 161" bis 164" in an sich bekannter Weise mittels Frequenzvariation und Puls-Pause-Verhältnissen regeln. Dank der Überwachung der Versorgungsspannung mit Hilfe des Spannungsmessgerätes 50'' kann der Mikrocontroller 102'' die Regelung an den aktuellen Wert der Versorgungsspannung U_{Ver} anpassen. Durch eine Rückmeldung des aktuellen Wertes des Ausgangsstroms Iₐ und/oder der Ausgangsspannung Uₐ kann der Mikrocontroller 102" zudem das Ausgangssignal des Schaltnetzteils 10" genau nachregeln. In all den beschriebenen Fällen stellt der Mikrocontroller 102" die geeigneten Steuersignale an den Ausgänge A1 bis A12 bereit.

Angemerkt sei noch, dass die Spannungsversorgungseinrichtung 235" die Signalverstärker 220" bis 223" und die Spannungsversorgungseinrichtung 230" die Signalverstärker 260 bis 264 und den Mikrocontroller 102" mit Energie speisen können.

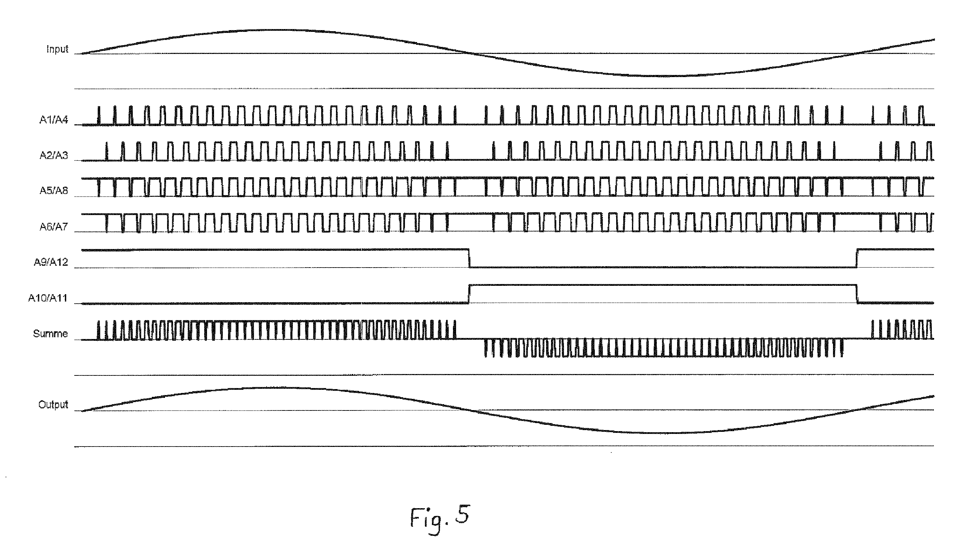

Die Funktionsweise der in Fig. 4 beispielhaft gezeigten, als Strommesswandler fungierenden Schaltungsanordnung 5" kann in Verbindung mit den in Fig. 5 dargestellten Zeitdiagrammen erläutert.

Angemerkt sei, dass bei der folgenden Beschreibung der Funktionsweise der Schaltungsanordnung 5" vorausgesetzt wird, dass die Versorgungsspannung an den Eingangsklemmen 20'', 22'' des Schaltnetzteils 10'' konstant ist.

Weiterhin sei angemerkt, dass die Schaltungsanordnung 5" im vorliegenden Beispiel derart implementiert ist, dass ein in den Diagrammen dargestellter High-Pegel eines Steuersignals bedeutet, dass der jeweilige Schalter geschlossen ist, während ein Low-Pegel eines Steuersignals bedeutet, dass der jeweilige Schalter offen ist.

Im Unterschied zu Fig. 2 enthält Fig. 5 zusätzlich die an den Ausgängen A9/A12 und A10/A11 des Mikrocontrollers 102" anliegenden Ansteuersignale für die Halbleiterschaltelemente 251 und 254 bzw. 252 und 253. Alle übrigen Ansteuersignale stimmen im Wesentlichen überein.

Ein Vorteil der beispielhaften, als Strommesswandler betreibbaren Schaltungsanordnung 5. 5' bzw. 5" kann darin gesehen werden, dass sie nachträglich montiert und auch bei Stromstärken oberhalb von 1000 A eingesetzt werden kann.

Obwohl das in Fig. 1 gezeigte Schaltnetzteil 10, das in Fig. 3 gezeigte Schaltnetzteil 10' und das in Fig. 4 gezeigte Schaltnetzteil 10" beispielhaft als regelbarer Gegentaktflusswandler im Vollbrücke realisiert wird, kann das jeweilige Schaltnetzteil 10, 10' und 10" die unterschiedlichsten Netztopologien, wie zum Beispiel die eines Abwärtswandler mit Speicherdrossel, eines SEPIC-Konverters, eines Sperrwandler oder dergleichen annehmen.

Die jeweils als Vollbrücke ausgebildeten Schalteinrichtungen 120 und 130, 120' und 130' bzw. 120" und 130" können auch als Halbbrücke ausgebildet sein.

Dank der besonderen Schaltungsanordnung, die ein Schaltnetzteil, einen Transformator und eine programmierbare Steuereinrichtung aufweist, ist es nunmehr möglich, unter Ausführung entsprechender Regelalgorithmen auf alle möglichen Anwendungsgebiete zu reagieren und ein Ausgangssignal entsprechend dem angelegten Eingangssignal auszuregeln. Das Eingangssignal kann ein beliebiges Gleich- oder Wechselspannungssignal sein, dem dann der Ausgangsstrom oder die Ausgangsspannung folgen kann. Verallgemeinernd gesprochen illustriert die anhand der Fig. 1 und 2 beispielhaft beschriebene Ausführungsform eine Schaltungsanordnung 5 zur Signalwandlung, die ein Schaltnetzteil 10 mit einem Transformator 60 aufweist. An der Primärseite bzw. Primärwicklung des Transformators 60 ist eine erste ansteuerbare Schalteinrichtung 120 zum Erzeugen eines Wechselsignals angeschaltet. An der Sekundärseite bzw. Sekundärwicklung des Transformators 60 sind eine zweite ansteuerbare Schalteinrichtung 130 sowie ein Tiefpassfilter 70, 75 angeschaltet.

Angemerkt sei, dass die zweite ansteuerbare 130 Schalteinrichtung bezüglich der sekundärseitigen Anschlüsse des Transformators 60 vorzugsweise als Polaritätswechsler fungieren kann.

Die Schaltungsanordnung 5 weist ferner eine vorzugsweise programmierbare Steuereinrichtung 100 mit einem Eingang 110, 112 zum Anlegen eines Eingangssignals Uₑ auf. Die Steuereinrichtung 100 ist dazu ausgebildet, unter Ansprechen auf ein Eingangssignal Uₑ die erste Schalteinrichtung 120 und die zweite Schalteinrichtung 130 derart anzusteuern, dass das Schaltnetzteil 10 ausgangsseitig ein dem Eingangssignal entsprechendes Ausgangssignal liefert.

Der Begriff "Signalwandlung" bedeutet unter anderem, dass in Abhängigkeit von einem Eingangswechselsignal ein Ausgangswechselsignal vorbestimmbarer Größe, in Abhängigkeit von einem negativen Eingangsgleichsignal ein negatives Ausgangsgleichsignal vorbestimmbarer Größe oder in Abhängigkeit von einem positiven Eingangsgleichsignal ein positives Ausgangsgleichsignal erzeugt werden kann.

Gemäß einer vorteilhaften Ausgestaltung wird als Eingangssignal ein Wechselsignal verwendet. In diesem Fall ist die Steuereinrichtung 100 dazu ausgebildet, unter Ansprechen auf das Eingangswechselsignal die erste Schalteinrichtung 120 und die zweite Schalteinrichtung 130 derart anzusteuern, dass das Schaltnetzteil 10 ausgangsseitig ein Ausgangswechselstromsignal definierter Größe liefert.

Beispielsweise liefert die Schaltungsanordnung 5 ein Ausgangswechselstromsignal mit einem effektiven Ausgangsstrom von 5A. Eine solche Schaltungsanordnung 5 kann in einen Strommesswandler implementiert werden, der als Stromwandler 90 beispielsweise eine Rogowskispule verwendet.

Gemäß einer weiteren vorteilhaften Ausgestaltung ist das Schaltnetzteil 10 als Gegentaktflusswandler ausgebildet, wobei die erste Schalteinrichtung 120 und die zweite Schalteinrichtung 130 jeweils eine Vollbrücke mit vier Schaltelementen bilden können.

Um Ausgangssignale präzise nachregeln und/oder die Regelung auf den aktuellen Wert einer am Schaltnetzteil 10 anliegenden Versorgungsspannung U_{Ver} anpassen zu können, ist die Steuereinrichtung 100 dazu ausgebildet, unter Ansprechen auf ein Ausgangssignal und/oder ein an der ersten Schalteinrichtung anliegendes Signal die erste Schalteinrichtung 120 und die zweite Schaltreinrichtung 130 derart anzusteuern, dass das Schaltnetzteil 10 ausgangsseitig ein dem Eingangssignal entsprechendes Ausgangssignal liefert.

Vorzugsweise handelt es sich bei der Steuereinrichtung 100 um einen digitalen Signalprozessor oder einen Mikrocontroller.

Eine vorteilhafte Weiterbildung der in Fig. 1 gezeigten Schaltungsanordnung 5 ist in Fig. 3 gezeigt. Die Schaltungsanordnung 5' weist ein Schaltnetzteil 10' mit einem Transformator 60' auf, an dessen Primärseite eine erste ansteuerbare Schalteinrichtung 120' zum Erzeugen eines Wechselsignal angeschaltet ist und an dessen Sekundärseite eine zweite ansteuerbare Schalteinrichtung 130' und ein Tiefpass 71, 72, 75 angeschaltet sind. Die Schaltungsanordnung weist ferner eine Steuereinrichtung 102 mit einem Eingang 110', 112' zum Anlegen eines Eingangssignals uₑ auf, wobei die Steuereinrichtung 102 dazu ausgebildet ist, unter Ansprechen auf ein Eingangssignal uₑ die erste und zweite Schalteinrichtung 120' bzw. 130' derart anzusteuern, dass das Schaltnetzteil 10' ausgangsseitig, also an den Klemmen 80', 82' ein dem Eingangssignal uₑ entsprechendes Ausgangssignal liefert, wobei die zweite ansteuerbare Schalteinrichtung 130' wenigstens zwei Halbleiterschalteinrichtungen 170, 180, 190, 200 enthält, die jeweils zwei antiseriell geschaltete Halbleitertransistoren 171 und 172, 181 und 182, 191 und 192 bzw. 201 und 202 aufweisen.

Vorteilhafterweise sind die Halbleitertransistoren niederohmige Feldeffekttransistoren.

Die Steuereinrichtung 102 kann dazu ausgebildet sein, unter Ansprechen auf ein Ausgangssignal des Schaltnetzteils 10' und/oder ein an der ersten Schalteinrichtung 120' anliegendes Signal die erste Schalteinrichtung 120' und die zweite Schalteinrichtung 30' derart anzusteuern, dass das Schaltnetzteil 10' ausgangsseitig ein dem Eingangssignal Uₑ entsprechendes Ausgangssignal liefert.

Gemäß einer vorteilhaften Ausführungsform ist das Eingangssignal uₑ ein Wechselsignal und die programmierbare Steuereinrichtung 102 kann dazu ausgebildet sein, unter Ansprechen auf das Eingangswechselsignal uₑ die erste und zweite Schalteinrichtung 120' bzw. 130' derart anzusteuern, dass das Schaltnetzteil 10' ausgangsseitig ein Ausgangswechselsignal liefert.

Vorteilhafterweise weisen die erste Schalteinrichtung 120' und die zweite Schalteinrichtung 130' jeweils vier Halbleiterschalteinrichtungen 161-164 bzw. 170-200 auf, die jeweils zu einer Vollbrücke verschaltet sind, wobei alle Halbleiterschalteinrichtungen 170, 180, 190 und 200 der zweiten Schalteinrichtung 130' jeweils zwei antiseriell geschaltete Halbleitertransistoren 171 und 17, 181 und 182, 191 und 192 bzw. 201 und 202 aufweisen.

Eine weitere vorteilhafte Weiterbildung der in Fig. 1 gezeigten Schaltungsanordnung ist in Fig. 4 gezeigt. Die Schaltungsanordnung 5'' weist ein Schaltnetzteil 10'' mit einem Transformator 60'' auf, an dessen Primärseite eine erste ansteuerbare Schalteinrichtung 120'' zum Erzeugen eines Wechselsignal angeschaltet ist und an dessen Sekundärseite eine zweite ansteuerbare Schalteinrichtung 130'', eine dritte ansteuerbare Schalteinrichtung 280 und ein Tiefpass 71'', 72'', 75" angeschaltet sind. Ferner weist die Schaltungsanordnung 5" eine Steuereinrichtung 102" mit einem Eingang 110'', 112" zum Anlegen eines Eingangssignals uₑ auf, wobei die Steuereinrichtung 102'' dazu ausgebildet ist, unter Ansprechen auf ein Eingangssignal uₑ die erste Schalteinrichtung 120'', die zweite Schalteinrichtung 130" und die dritte Schalteinrichtung 280 derart anzusteuern, dass das Schaltnetzteil 10" ausgangsseitig, d. h. an den Klemmen 80'', 82'' ein dem Eingangssignal uₑ entsprechendes Ausgangssignal liefert.

Ein Vorteil der Schaltungsanordnung 5'' liegt darin, dass die zweite und dritte Schalteinrichtung, welche einen Wechselrichter bilden, nur mit der Frequenz des Ausgangssignals geschaltet werden müssen. Auf diese Weise können dynamische Verluste beim Umschalten der Schaltelemente reduziert werden.

Vorzugsweise weisen die erste, zweite und dritte Schalteinrichtung 120'', 130'' bzw. 280 jeweils vier Halbleiterschaltelemente 161''-164'', 241-244, 251-254 auf, die jeweils zu einer Vollbrücke verschaltet sind.

Ist das Eingangssignal uₑ ein Wechselsignal, kann die Steuereinrichtung 102" dazu ausgebildet sein, unter Ansprechen auf das Eingangswechselsignal uₑ die erste und zweite Schalteinrichtung 120''bzw. 130" und die dritte Schalteinrichtung 280 derart anzusteuern, dass das

Schaltnetzteil 10'' ausgangsseitig ein Ausgangswechselsignal liefert.

Vorzugsweise ist die Steuereinrichtung 102'' dazu ausgebildet ist, unter Ansprechen auf ein Ausgangssignal des Schaltnetzteils 10'' und/oder ein an der ersten Schalteinrichtung 120'' anliegendes Signal die erste Schalteinrichtung 120'', die zweite Schalteinrichtung 130" und die dritte Schalteinrichtung 280 derart anzusteuern, dass das Schaltnetzteil 10'' ausgangsseitig ein dem Eingangssignal Uₑ entsprechendes Ausgangssignal liefert.

Die Schaltnetzteile 10' und 10'' können jeweils als regelbarer Gegentaktflusswandler ausgebildet sein.

Die vorzugsweise programmierbare Steuereinrichtungen 102 und 102'' können jeweils als ein digitaler Signalprozessor oder Mikrocontroller ausgeführt sein.

## Patentansprüche

1. Schaltungsanordnung (5, 5', 5'') zur Signalwandlung aufweisend:
ein Schaltnetzteil (10, 10', 10'') mit einem Transformator (60, 60', 60''), an dessen Primärseite eine erste ansteuerbare Schalteinrichtung (120, 120', 120'') zum Erzeugen eines Wechselsignal angeschaltet ist und an dessen Sekundärseite eine zweite ansteuerbare Schalteinrichtung (130, 130', 130'') und ein Tiefpass (70, 75; 71, 72, 75; 71", 72'', 75'') angeschaltet sind, und
eine Steuereinrichtung (100, 102, 102") mit einem Eingang (110, 112; 110', 112'; 110", 112") zum Anlegen eines Eingangssignals (uₑ), wobei die Steuereinrichtung (100, 102, 102") dazu ausgebildet ist, unter Ansprechen auf ein Eingangssignal (uₑ) die erste und zweite Schalteinrichtung (120, 130; 120', 130'; 120'', 130'') derart anzusteuern, dass das Schaltnetzteil (10, 10', 10") ausgangsseitig (80, 82; 80', 82'; 80'', 82'') ein dem Eingangssignal (uₑ) entsprechendes Ausgangssignal liefert.

2. Schaltungsanordnung (5') nach Anspruch 1,
**dadurch gekennzeichnet, dass**
die zweite ansteuerbare Schalteinrichtung (130') wenigstens zwei Halbleiterschalteinrichtungen (170, 180, 190, 200) enthält, die jeweils zwei antiseriell geschaltete Halbleitertransistoren (171 und 172, 181 und 182, 191 und 192, 201 und 202) aufweisen.

3. Schaltungsanordnung nach Anspruch 2,
**dadurch gekennzeichnet, dass**
die Halbleitertransistoren (170, 175; 180, 185; 190, 195; 200, 205) niederohmige Feldeffekttransistoren sind.

4. Schaltungsanordnung nach Anspruch 2 oder 3,
**dadurch gekennzeichnet, dass**
die erste und zweite Schalteinrichtung (120', 130') jeweils vier Halbleiterschalteinrichtungen (161-164; 170, 180, 190, 200) aufweisen, die jeweils zu einer Vollbrücke verschaltet sind, wobei die Halbleiterschalteinrichtungen (170, 180, 190, 200) der zweiten Schalteinrichtung (130') jeweils zwei antiseriell geschaltete Halbleitertransistoren ((171 und 172, 181 und 182, 191 und 192, 201 und 202) aufweisen.

5. Schaltungsanordnung nach einem der vorstehenden Ansprüche,
**dadurch gekennzeichnet, dass**
das Eingangssignal (uₑ) ein Wechselsignal ist und die Steuereinrichtung (100, 102) dazu ausgebildet ist, unter Ansprechen auf das Eingangswechselsignal (uₑ) die erste und zweite Schalteinrichtung (120, 130; 120', 130') derart anzusteuern, dass das Schaltnetzteil (10, 10') ausgangsseitig ein Ausgangswechselsignal liefert.

6. Schaltungsanordnung nach einem der vorstehenden Ansprüche,
**dadurch gekennzeichnet, dass**
die Steuereinrichtung (100, 102) dazu ausgebildet ist, unter Ansprechen auf ein Ausgangssignal des Schaltnetzteils und/oder ein an der ersten Schalteinrichtung (120, 120') anliegendes Signal die erste und zweite Schalteinrichtung (120, 130; 120', 130') derart anzusteuern, dass das Schaltnetzteil (10, 10') ausgangsseitig ein dem Eingangssignal (Uₑ) entsprechendes Ausgangssignal liefert.

7. Schaltungsanordnung (5'') nach Anspruch 1,
**dadurch gekennzeichnet, dass**
an der Sekundärseite des Transformators (60'') eine dritte ansteuerbare Schalteinrichtung (280) angeschaltet ist, und dass
die Steuereinrichtung (102'') dazu ausgebildet ist, unter Ansprechen auf ein Eingangssignal (uₑ) die erste Schalteinrichtung (120''), die zweite Schalteinrichtung (130'') und die dritte Schalteinrichtung (280) derart anzusteuern, dass das Schaltnetzteil (10'') ausgangsseitig (80'', 82'') ein dem Eingangssignal (uₑ) entsprechendes Ausgangssignal liefert.

8. Schaltungsanordnung nach Anspruch 7,
**dadurch gekennzeichnet, dass**
die erste, zweite und dritte Schalteinrichtung (120'', 130'', 280) jeweils vier Halbleiterschaltelemente (161''-164'', 241-244, 251-254) aufweisen, die jeweils zu einer Vollbrücke verschaltet sind.

9. Schaltungsanordnung nach Anspruch 7 oder 8,
**dadurch gekennzeichnet, dass**
das Eingangssignal (uₑ) ein Wechselsignal ist und die Steuereinrichtung (102'') dazu ausgebildet ist, unter Ansprechen auf das Eingangswechselsignal (uₑ) die erste, zweite und dritte Schalteinrichtung (120'', 130'', 280) derart anzusteuern, dass das Schaltnetzteil (10'') ausgangsseitig ein Ausgangswechselsignal liefert.

10. Schaltungsanordnung nach einem der Ansprüche 7 bis 9, **dadurch gekennzeichnet, dass**
die Steuereinrichtung (102'') dazu ausgebildet ist, unter Ansprechen auf ein Ausgangssignal des Schaltnetzteils (10'') und/oder ein an der ersten Schalteinrichtung (120'') anliegendes Signal die erste Schalteinrichtung (120''), die zweite Schalteinrichtung (130'') und die dritte Schalteinrichtung (280) derart anzusteuern, dass das Schaltnetzteil (10'') ausgangsseitig ein dem Eingangssignal (Uₑ) entsprechendes Ausgangssignal liefert.

11. Schaltungsanordnung nach einem der vorstehenden Ansprüche,
**dadurch gekennzeichnet, dass**
das Schaltnetzteil (10; 10'; 10'') als regelbarer Gegentaktflusswandler ausgebildet ist.

12. Schaltungsanordnung nach einem der vorstehenden Ansprüche,
**dadurch gekennzeichnet, dass**
die Steuereinrichtung (100; 102; 102'') ein digitaler Signalprozessor oder ein Mikrocontroller ist.
